(19) Europäisches Patentamt
European Patent Office
Office européen des brevets

(11) EP 2 731 115 B1

(12) **EUROPEAN PATENT SPECIFICATION**

(45) Date of publication and mention of the grant of the patent:
**22.10.2014 Bulletin 2014/43**

(51) Int Cl.:
***H01G 9/20*** *(2006.01)*

(21) Application number: **12191650.6**

(22) Date of filing: **07.11.2012**

(54) **Dye sensitized solar cells and methods of making same**

Farbstoffsensibilisierte Solarzellen und Herstellungsverfahren dafür

Cellules solaires à colorant et leurs procédés de fabrication

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**14.05.2014 Bulletin 2014/20**

(73) Proprietor: **Honeywell Romania S.R.L.**
**014459 Bucharest (RO)**

(72) Inventors:
- **Mihaila, Mihai N.**
  **023555 Bucharest, Sector 1 (RO)**
- **Serban, Bogdan Catalin**
  **60000 Bucharest, sector 2 (RO)**
- **Buiu, Octavian**
  **Morristown, NJ 07962-2245 (US)**
- **Avramesu, Viorel**
  **030342 Bucharest (RO)**

(74) Representative: **Houghton, Mark Phillip**
**Patent Outsourcing Limited**
**1 King Street**
**Bakewell, Derbyshire DE45 1DZ (GB)**

(56) References cited:
- **XIA WU ET AL: "Nanosized Anatase TiO2 Single Crystals with Tunable Exposed (001) Facets for Enhanced Energy Conversion Efficiency of Dye-Sensitized Solar Cells", ADVANCED FUNCTIONAL MATERIALS, WILEY - V C H VERLAG GMBH & CO. KGAA, DE, vol. 21, no. 21, 8 November 2011 (2011-11-08), pages 4167-4172, XP001571461, ISSN: 1616-301X, DOI: 10.1002/ADFM.201100828 [retrieved on 2011-08-25]**
- **JIANMING LI ET AL: "Tetragonal faceted-nanorods of anatase TiO2 single crystals with a large percentage of active {100} facets", CHEMICAL COMMUNICATIONS, vol. 46, no. 13, 1 January 2010 (2010-01-01), page 2301, XP55049865, ISSN: 1359-7345, DOI: 10.1039/b923755k**
- **ZONGYAN ZHAO ET AL: "Surface properties and electronic structure of low-index stoichiometric anatase TiO2 surfaces", JOURNAL OF PHYSICS: CONDENSED MATTER, INSTITUTE OF PHYSICS PUBLISHING, BRISTOL, GB, vol. 22, no. 17, 5 May 2010 (2010-05-05), page 175008, XP020173957, ISSN: 0953-8984**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 731 115 B1

## Description

### FIELD OF INVENTION

The present disclosure relates to dye-sensitized solar cells and a method for making same. More particularly, the disclosure relates to a dye-sensitized solar cell comprising a titanium dioxide ($TiO_2$) nanoparticulate layer having a higher percentage of {100} facets relative to {101} and {001} facets.

### BACKGROUND OF THE INVENTION

Dye-sensitized solar cells (DSSC) provide a technically and economically credible alternative concept to present day p-n junction photovoltaic devices. M. Grätzel, Journal of Photochemistry and Photobiology C: Photochemistry Reviews 4: 145-153 (2003). *See also,* Wei-Hao Lai et al., Journal of Photochemistry and Photobiology A: Chemistry 195: 307-313 (2008); and Xiao-Feng Wang et al., Langmuir 26: 6320-6327 (2010). In contrast to the conventional systems where the semiconductor assumes both the task of light absorption and charge carrier transport, the two functions are separated in the case of DSSCs. Light is absorbed by a sensitizer, which is anchored to the surface of a semiconductor. Charge separation takes place at the interface via photo-induced electron injection from the dye into the conduction band of the solid. Carriers are transported in the conduction band of the semiconductor to the charge collector. The use of sensitizers having a broad absorption band in conjunction with oxide films of nanocrystalline morphology permits the harvesting of a large fraction of sunlight, with nearly quantitative conversion of incident photons into electric current over a large spectral range extending from the UV to the near IR region. A further relevant disclosure can be found in Xia Wu et al, "Nano sized anatase TiO2 single crystals with tunable exposed (001) assets for enhanced energy conversion efficiency of dye-sensitised solar cells", advanced functional materials, Wiley, volume 21, 21, 8 November 2011, pages 4167-4172.

One main focus in the context of DSSCs has been the nature of the dye and how the dye can be changed or improved to give more efficient DSSCs by maximizing the value of the short circuit current ($I_{sc}$), open circuit voltage ($V_{oc}$), and filling factor (FF) of the cells. There has been less of a focus on how the DSSC efficiency might be improved by changing/modifying the shape of the $TiO_2$ crystals used to prepare the DSSCs such that they have a higher percentage of certain facets, *e.g.*, {100} facets. The embodiments of the present invention address this deficiency in the art.

### SUMMARY OF THE INVENTION

The present invention in its various aspects is as set out in the appended claims. The embodiments of the present invention focus on DSSCs comprising a titanium dioxide ($TiO_2$) nanoparticulate layer having a higher percentage of {100} facets relative to {101} and {001} facets. The $I_{sc}$ of such cells depends on the facility with which a cromophore (*e.g.*, a dye) can inject electrons into the DSSC's anode, which usually comprises a $TiO_2$ nanoparticle layer. The inventors have surprisingly and unexpectedly found that the facility with which a chromophore can inject electrons into a DSSC $TiO_2$ anode depends on the surface crystallographic plane of the $TiO_2$ nanoparticles. The inventors have found, for example, that for some chromophores the $I_{sc}$ can be maximized when the $TiO_2$ nanoparticulate layer comprised in a DSSC has a higher percentage of {100} facets relative to {101} and {001} facets.

In one embodiment the invention relates to a dye-sensitized solar cell comprising one or more dyes and a TiO2 nanoparticulate layer having a higher percentage of {100} facets relative to {101} and {001} facets.

In other embodiments, the invention relates to a method of preparing a dye sensitized solar cell comprising: forming a first conductive layer on a first substrate; forming a barrier layer on the first conductive layer; forming a $TiO_2$ nanoparticulate layer having a higher percentage of {100} facets relative to {101} and {001} facets; forming a $TiO_2$ microparticulate layer on the $TiO_2$ nanoparticulate layer; disposing a dye on the $TiO_2$ nanoparticulate layer and/or the $TiO_2$ microparticulate layer; forming a second conductive layer on a second substrate; and providing a regenerating composition between the second conductive layer and the barrier layer.

In still other embodiments, the invention relates to a method of preparing a dye sensitized solar cell comprising: providing a first substrate comprising a first conductive layer; and forming a TiO2 nanoparticulate layer having a higher percentage of {100} facets relative to {101} and {001} facets on the substrate.

In yet other embodiments, the invention relates to a method of obtaining high short circuit current in a dye sensitized solar cell comprising aligning the LUMO level of a cromophore with one or more peaks in the electronic density of states of the anode material. In some embodiments, the anode material comprises $TiO_2$. In other embodiments, the $TiO_2$ comprises nanoparticles comprising a higher percentage of {100} facets relative to {101} and {001} facets.

## BRIEF DESCRIPTION OF THE DRAWINGS

FIG. 1 is a cross-section of a DSSC prepared by the methods disclosed herein.

FIGS. 2A to 2F are cross-sections of a DSSC according to an embodiment of the invention, as it is prepared by the methods disclosed herein.

FIG. 3 is a cross-section of a DSSC according to an embodiment of the invention.

FIG. 4 is a flow chart of the method of preparing a DSSC according to an embodiment of the invention.

FIG. 5 is a plot of the short circuit current ($I_{sc}$) in mA/cm$^2$ versus the driving force ($\Delta G_1$) in eV for 161 organic dye molecules taken from the literature.

FIG. 6 is a plot of the electronic density of states calculated for the Ti atoms in the second atomic layer of the {100} $TiO_2$ surface superimposed on a plot of the short circuit current ($I_{sc}$) in mA/cm$^2$ versus the driving force ($\Delta G_1$) for 161 organic dye molecules taken from the literature.

## DETAILED DESCRIPTION OF THE INVENTION

Embodiments of the present invention relate to a method of preparing a dye-sensitized solar cell. Making reference to FIG. 1, the method comprises forming a first conductive layer 12 on a first substrate 10. A barrier layer 11 is then formed on the conductive layer 12. A nanoparticulate layer 14 is subsequently formed on the metal oxide layer 11. A microparticulate layer 13 is subsequently formed on the nanoparticulate layer 14. The nanoparticulate layer 14 and the microparticulate layer 13 are subsequently functionalized with a dye 16. A second substrate 20 comprising a second conductive layer 22 is provided and a regenerating composition 24 (*e.g.*, an electrolyte composition for regenerating the dye 16) is applied between the first substrate 10 and the second substrate 20, thereby completing the dye-sensitized solar cell 30. Those of skill in the art will appreciate that the regenerating composition 24, though shown as a layer in FIG. 1, will permeate the space between the barrier layer 11 and the second conductive layer 22. In some embodiments, the second substrate 20 comprises at least one orifice 18 that goes through the second substrate 20 and the second conductive layer 22 and allows for the application of the regenerating composition 24.

Although the layers shown in FIG. 1 (and others) are shown as being in direct contact with one another, it should be understood that, in some embodiments, there could be one or more layers in between the layers depicted in FIG. 1.

More specifically, referring to FIG. 2A, a first substrate 10 is provided. The first substrate 10 may comprises any suitable material and may be rigid, flexible, transparent, semitransparent, metallic or semiconducting. In some embodiments, the first substrate 10 may be glass or polymeric in nature, *e.g.*, flexible polymers including, but not limited to, poly(ethylene terephthalate, poly(ethylene naphthalate) or mixtures thereof.

In FIG. 2A, a first conductive layer 12 is formed on the first substrate 10 to provide a path for electron flow. In some embodiments, the first conductive layer 12 may be substantially smooth. In other embodiments, the first conductive layer 12 may comprise protrusions that may be characterized as nanowires or nanorods. *See, e.g.,* Published U.S. Patent Appl. No. 2008/0041446. In some embodiments, the first conductive layer 12 is formed by an *in situ* process including, but not limited to, thermal evaporation, sputtering or other applicable processes well-known in the art. For example, the first conductive layer 12, comprising, *e.g.*, indium tin oxide, may be formed on the first substrate 10, and then stacked and saturated in a vapor of indium tin oxide by thermal evaporation. The first conductive layer 12 is formed at a temperature, *e.g.*, between 400°C and 950°C for 5 minutes to 60 minutes.

In some embodiments, the first conductive layer 12 comprises indium tin oxide (ITO), aluminum doped zinc oxide (AZO), antimony doped tin dioxide (ATO), fluorine doped tin oxide (FTO), tin-doped indium oxide or other semiconductor oxides.

In some embodiments, the first substrate 10 is flexible. In some embodiments, the flexible substrate comprises poly(ethylene terephthalate) coated with a first conductive layer 12 comprising tin-doped indium oxide. In other embodiments, the flexible substrate comprises poly(ethylene naphthalate) coated with tin-doped indium oxide.

As shown in FIG. 2B, in some embodiments a barrier layer 11 is formed on the first conductive layer 12. The barrier layer 11 may be formed by, *e.g.*, immersing the first substrate 10, comprising the conductive layer 12, in a $TiCl_4$ solution at 70°C. Following the immersion in the $TiCl_4$ solution, the first substrate 10 is heated at about 450°C for about 40 minutes. The resulting barrier layer 11 is, in some embodiments, a $TiO_2$ nanoparticulate layer having a 100-150 nm

thicknes and having nanoparticles having an average diameter of about 3 nm. The barrier layer 11 is formed to, among other things, avoid contact between the conductive layer 12 and the regenerating composition 24.

As shown in FIG. 2C, a nanoparticulate layer 14 is then formed on the barrier layer 11 by, *e.g.*, the doctor blade method or any other method known in the art. The nanoparticulate layer 14 is formed to, among other things, increase surface contact with the subsequently applied dye-sensitizer. The nanoparticulate layer 14 may take the form of nanoparticles, nanorods (*e.g.*, nanowires) or quantum dots. In some embodiments, the nanoparticulate layer 14 comprises a titanium dioxide ($TiO_2$) nanoparticulate layer 14 having a high percentage of {100} facets. A titanium dioxide ($TiO_2$) nanoparticulate layer 14 having a high percentage of {100} facets may be obtained by forming a nanoparticulate layer 14 comprising $TiO_2$ nanoparticles and heating the newly-formed nanoparticulate layer 14 at 450°C, for about 30 minutes. *See, e.g.,* J. Li and D. Xu, Chem. Commun. 46: 2301.

In some embodiments, the nanoparticulate layer 14 is prepared in such a way as to have $TiO_2$ crystals having a higher percentage of {100} facets relative to {101} and {001} facets. As used herein, the term "higher percentage of {100} facets relative to {101} and {001} facets" refers to a percentage of {100} facets of at least about 51%, at least about 55%, at least about 60%, at least about 65%, at least about 70%, at least about 75% or at least about 80% {100} facets. The term also refers to a percentage of {100} facets of from about 51% to about 80%, *e.g.,* about 51% to about 70%, about 51% to about 70% or about 51% to about 60% {100} facets.

In FIG. 2D, a microparticulate layer 13 is formed on the nanoparticulate layer 14. The microparticulate layer 13 may be formed by, *e.g.*, the doctor blade method or any other method known in the art. The newly-formed microparticulate layer 13 is heated at 450°C, for about 30 minutes and then allowed to cool slowly to a temperature of about 80°C. It is at about this temperature that the dye 16 is provided.

In FIG. 2E, a dye 16 is provided in the nanoparticulate layer 14 and in the microparticulate layer 13. In some embodiments, the dye 16 is adsorbed on the nanoparticulate layer 14 and the microparticulate layer 13. In some embodiments, the dye 16 comprises one or more dyes comprising:

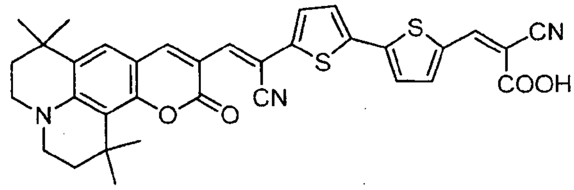
,

also known as NKX-2883 (Wang et al., Adv. Mater: 19: 1138 (2007));

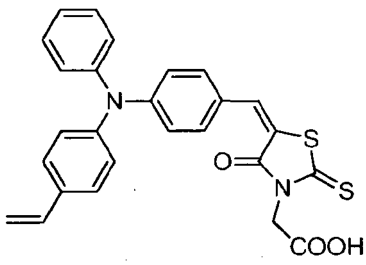
,

also known as TPAR4 (Liang et al., J. Phys. Chem. 111: 4464 (2007));

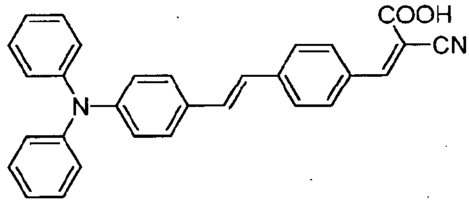
,

also known as TA-St-CA (Hwang, Chem. Commun: 4887 (2007)); or mixtures thereof.

While not being bound by theory, since the dye 16 couples to the surface atoms of the $TiO_2$ in the nanoparticulate layer 14, it results that the $TiO_2$ bulk distribution of electronic states is less important with regard electron transfer than

the $TiO_2$ surface distribution of electronic states.

Since $TiO_2$ exposes many crystallographic faces, especially those of low indexes, such as {101}, {100}, and {001}, it results that a $TiO_2$ surface controls both the coupling matrix element of a dye 16 (electron donor)-$TiO_2$ (electron acceptor) pair ($H_{DA}$) and the reorganization energy ($\lambda$) and, as a result, the electron transfer rate ($k_{ET}$) from the dye 16's lowest unoccupied molecular orbital (LUMO) to $TiO_2$. The coupling matrix element, reorganization energy, and the electron transfer rate are related as follows:

$$k_{ET} = 2\pi/\hbar \left| H_{DA} \right|^2 FC$$

where h is the Planck constant; and FC is the Franck-Condon factor:

$$FC = (4\pi\lambda k_B T)^{-1/2} \exp[-(\Delta G_1 + \lambda)^2/4\lambda k_B T],$$

where $k_B$ is the Boltzmann constant; and $\Delta G_1$ is the driving force at the dye 16/$TiO_2$ interface.

Electron transfer from the dye 16 to the $TiO_2$ is accompanied by nuclear motion on both sides of the dye 16 and n-type conductor interface. According to the Franck-Condon principle, the whole system reorganizes in order for the electron transfer to occur. The energy required for all structural adjustments necessary for the transfer of the electron is the reorganization energy, $\lambda$. The reorganization energy is the summation of the energy of all vibration modes (phonons) excited during the electron transfer. As shown above, the Franck-Condon factor depends on $\Delta G_1$ and $\lambda$. According to Marcus theory, for a given electronic coupling matrix element, the maximum transfer rate is obtained when $\Delta G_1 = \lambda$. In this case, the Franck-Condon factor is given by:

$$FC = (4\pi\lambda k_B T)^{-1/2} \exp[-\lambda/k_B T].$$

This equation indicates that the lower $\lambda$ is, the higher the Franck-Condon factor is. For low reorganization energy, the rate of charge transfer at the dye 16/$TiO_2$ interface will be high.

It is predicted that molecules having high $I_{sc}$ should feature it at $\Delta G_1$ values corresponding to the maxima in the $TiO_2$ surface electronic density of states.

Hundreds of dyes were developed in the last two decades and their capability to transfer electrons is highly different. FIG. 5 shows the dependence of the $I_{sc}$ on the $\Delta G_1$ for 161 organic dye molecules. These data were collected from literature. *See* A. Mishra et al., Angew. Chem. Int. Ed. 48: 2474-2499 (2009) and references therein. FIG. 6 compares the data from FIG. 5 with the electronic distribution of states calculated by Z. Zhao et al., Journal of Physics: Condensed Matter 22: 175008 (2010) for the Ti atoms in the second atomic layer of the {100} $TiO_2$ surface. Some molecules having high $I_{sc}$ values correspond to the peak values of the {100} surface electronic density of states. Such molecules are indicated by numbers and correspond to the molecules designed and synthesized by Wang et al., Adv. Mater: 19: 1138 (2007) (NKX-2883, denoted by the numeral 1 in FIG. 6); Liang et al., J. Phys. Chem. 111: 4464(2007) (TPAR4, denoted by numeral 2 in FIG. 6); and Hwang, Chem. Commun.: 4887 (2007) (TA-St-CA, denoted by numeral 3 in FIG. 6).

As predicted, therefore, molecules having high $I_{sc}$, such as NKX-2883, TPAR4, TA-St-CA, feature it at $\Delta G_1$ values corresponding to the maxima in the $TiO_2$ surface electronic density of states.

Referring to FIG. 2F, a second substrate 20 comprising a second conductive layer 22 is provided. The second conductive layer 22 is formed on the second substrate 20 by evaporation, sputtering, electroplating, deposition, or by any applicable process well-known in the art. The material of the second substrate 20 is the same or different from the material of the first substrate 10, as previously described. The second substrate 20 may comprise any suitable material and may be rigid, flexible, transparent, or semitransparent. In some embodiments, the second substrate 20 may be glass or polymeric (*e.g.,* poly(ethylene terephthalate or poly(ethylene naphthalate) in nature. The second conductive layer 22 may be metal comprising copper, platinum, silver, or any conductive material. In some embodiments, the second substrate 20 comprises at least one orifice 18 that goes through the scond substrate 20 and the second conductive layer 22 and allows for the application of the regenerating composition 24.

In FIG. 1, a regenerating composition 24 is applied (*e.g.*, by filling via orifice 18 that goes through the second substrate 20 and the second conductive layer 22) between the first substrate 10 and the second substrate 20, to regenerate the dye 16. Those of skill in the art will appreciate that the regenerating composition 24, though shown as a layer in FIG. 1, will permeate the space between the barrier layer 11 and the second conductive layer 22.

In some embodiments, the regenerating composition 24 comprises iodide ion and iodine. The regenerating composition 24 may be a solution of iodide ion and iodine. For example, the regenerating composition 24 comprises lithium iodide (LiI) and iodine ($I_2$) each at a concentration of from about 0.1 M to about 0.2 M in an appropriate solvent such as acetonitrile or a 5:1 mixture of acetonitrile/valeronitrile. In some embodiments, the regenerating composition 24 also comprises an imidazolium salt. Exemplary imidazolium salts include 1,2-dimethyl-3-propylimidazolium iodide and 1-butyl-2-methyl imidazolium iodide. In some embodiments, the regenerating composition 24 also comprises a substituted pyridine. Exemplary substituted pyridines include 4-tert-butyl pyridine. Other electrolytes include the Co(II)/Co(III) based redox couples.

Alternatively, the regenerating composition 24 may be in the form of a gel comprising iodide ion and iodine. *See, e.g.,* Published U.S. Patent Appl. No. 2008/0041446 and U.S. Patent No. 8,034,260, both of which are incorporated by reference as if fully set forth herein. Other regenerating compositions 24 are also known in the art and may be used in the embodiments of the present invention. *See, e.g.,* U.S. patent No. 8,222,515.

In some embodiments, the regenerating composition 24 comprises 2,2'7,7'-tetrakis-(N,N-di-p-methoxyphenyl-amine)-9,9'-spirobifluorene (spiro-MeOTAD) or any other substance that can serve to regenerate the dye comprised in the dye layer 16 by reducing the dye comprised in the dye layer 16.

Following application of the regenerating composition 24 (*e.g.*, by filling via orifice 18 that goes through the second substrate 20 and the second conductive layer) between the first substrate 10 and the second substrate 20, in some embodiments, a sealant (not shown) is applied to seal the DSSC. One of the functions of the sealant is to prevent the regenerating composition 24 from escaping from between the barrier layer 11 and the second conductive layer 22. Exemplary sealants include, but arc not limited to Surlyn® ethylene methacrylic acid copolymer resins available from DuPont™.

FIG. 3 shows a dye-sensitized solar cell 30 according to an embodiment of the invention. The dye 16 comprised in the nanoparticulate layer 14 and the microparticulate layer 13 is excited with light and transmits electrons into the nanoparticulate layer 14, when dye 16 absorbs solar energy. At this point, the dye 16 is in an oxidized state. As shown, an electric flow path 32 in FIG. 3, electrons are transmitted to the conductive layer 12 to the second conductive layer 22 to generate a current. Thereafter, electrons from regenerating composition 24 are provided to dye 16 for reduction of oxidized dye 16. The above oxidization and reduction of dye 16 is repeatedly performed to generate current continually.

FIG. 4 shows a flow chart for making a dye-sensitized solar cell according to an embodiment of the invention. A first substrate is provided, as step 100. A first conductive layer is formed on the first substrate, as step 102. A barrier layer is formed on the first conductive layer, as step 104. A nanoparticulate layer, comprising a plurality of nanoparticles, is formed on the barrier layer, as step 106, the nanoparticles having a higher percentage of {100} facets relative to {101} and {001} facets. A microparticulate layer is formed on the nanoparticulate layer, as step 107. A dye is then applied on the first substrate by dip coating, as step 108, such that the dye is present in the nanoparticulate layer and/or in the microparticulate layer. Thereafter, a second substrate is provided, as step 110, where the second substrate comprises a second conductive layer. As shown in step 112, a regenerating composition is applied between the substrates to yield a dye-sensitized solar cell, *e.g.*, through an orifice present on the second substrate, that goes through the second conductive layer. In some embodiments, a sealant is provided (step not shown) in a sealing step after the regenerating composition is applied.

## Claims

1. A dye-sensitized solar cell comprising one or more dyes and a $TiO_2$ nanoparticulate layer **characterized in that** the $TiO_2$ nanoparticulate layer has a higher percentage of {100} facets relative to {101} and {001} facets.

2. The dye-sensitized solar cell of claim 1, further comprising:

   a first conductive layer disposed on a first substrate;
   a barrier layer disposed on the first conductive layer;
   a $TiO_2$ nanoparticulate layer disposed on the barrier layer;
   a $TiO_2$ microparticulate layer disposed on the $TiO_2$ nanoparticulate layer;
   a dye disposed on the $TiO_2$ nanoparticulate layer and/or the $TiO_2$ microparticulate layer;
   a second conductive layer disposed on a second substrate; and
   a regenerating composition disposed between the second conductive layer and the $TiO_2$ microparticulate layer.

3. The dye-sensitized solar cell of claim 1, wherein the dye comprises a compound of the formula:

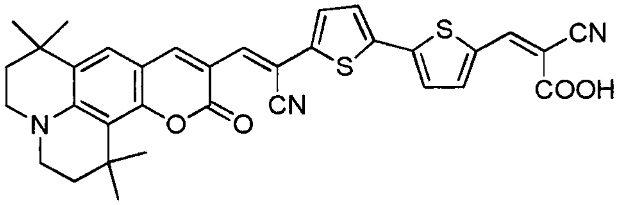

;

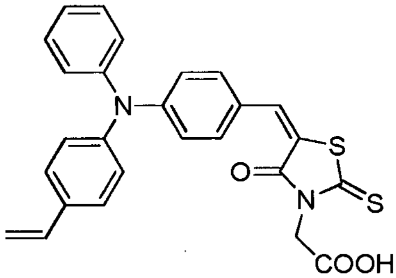

;

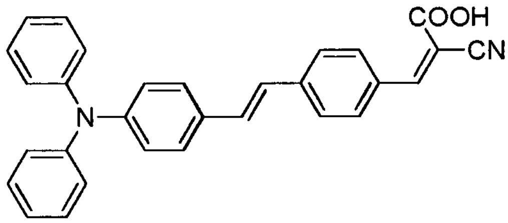

;

or
mixtures thereof.

**4.** The dye-sensitized solar cell of claim 2, wherein the percentage of {100} is at least about 51%, at least about 55%, at least about 60%, at least about 65%, at least about 70%, at least about 75% or at least about 80%.

**5.** The dye-sensitized solar cell of claim 2, wherein the percentage of {100} facets is 51% to about 80%, *e.g.*, about 51% to about 70%, about 51% to about 70% or about 51 % to about 60%.

**6.** A method of preparing a dye sensitized solar cell comprising:

providing a first substrate comprising a first conductive layer; and
forming a $TiO_2$ nanoparticulate layer **characterized in that** the $TiO_2$ nanoparticulate layer has a higher percentage of {100} facets relative to {101} and {001} facets on the substrate.

**7.** The method of claim 6, wherein a dye comprises a compound of the formula:
or mixtures thereof.

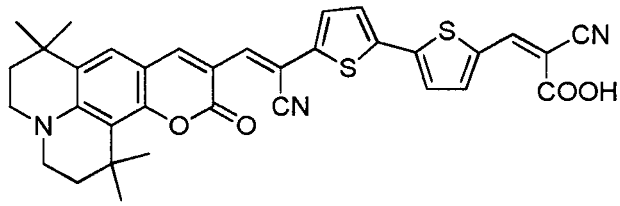

;

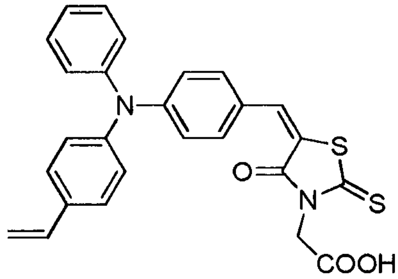

;

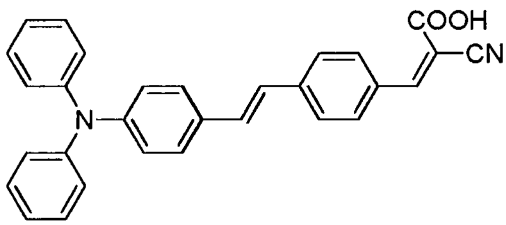

;

**8.** The method of claim 6 of preparing a dye sensitized solar cell comprising:

forming said first conductive layer on said first substrate;
forming a barrier layer on the first conductive layer;
forming said $TiO_2$ nanoparticulate layer having a higher percentage of {100} facets relative to {101} and {001} facets;
forming a $TiO_2$ microparticulate layer on the $TiO_2$ nanoparticulate layer;
disposing a dye on the $TiO_2$ nanoparticulate layer and/or the $TiO_2$ microparticulate layer;
forming a second conductive layer on a second substrate; and
providing a regenerating composition between the second conductive layer and the barrier layer.

**9.** The method of claim 8 or the dye-sensitized solar cell of claim 2, wherein the first and/or second substrate comprises glass or a flexible polymer.

**10.** The method or dye-sensitized solar cell of claim 9, wherein the first and/or second substrate comprises a flexible polymer comprising poly(ethylene terephthalate), poly(ethylene naphthalate) or mixtures thereof.

**11.** The method of claim 8 or the dye-sensitized solar cell of claim 2, wherein the first conductive layer comprises indium tin oxide (ITO), aluminum doped zinc oxide (AZO), antimony doped tin dioxide (ATO) or fluorine doped tin dioxide (FTO) or tin-doped indium oxide.

**12.** The method of claim 8 or the dye-sensitized solar cell of claim 2, wherein the regenerating composition comprises iodide ions and iodine.

13. The method of claim 8 or the dye-sensitized solar cell of claim 2, wherein the second conductive layer comprises platinum.

## Patentansprüche

1. Farbstoffsensibilisierte Solarzelle, umfassend einen oder mehrere Farbstoffe und eine $TiO_2$-Nanopartikelschicht, **dadurch gekennzeichnet, dass** die $TiO_2$-Nanopartikelschicht einen höheren Prozentsatz von {100}-Kristallflächen im Verhältnis zu {101}- und {001}-Kristallflächen aufweist.

2. Farbstoffsensibilisierte Solarzelle nach Anspruch 1, ferner umfassend:

   eine auf einem ersten Substrat angeordnete erste leitfähige Schicht;
   eine auf der ersten leitfähigen Schicht angeordnete Barriereschicht;
   eine auf der Barriereschicht angeordnete $TiO_2$-Nanopartikelschicht;
   eine auf der $TiO_2$-Nanopartikelschicht angeordnete $TiO_2$-Mikropartikelschicht;
   einen auf der $TiO_2$-Nanopartikelschicht und/oder der $TiO_2$-Mikropartikelschicht angeordneten Farbstoff;
   eine auf einem zweiten Substrat angeordnete zweite leitfähige Schicht; und
   eine zwischen der zweiten leitfähigen Schicht und der $TiO_2$-Mikropartikelschicht angeordnete Regenerationszusammensetzung.

3. Farbstoffsensibilisierte Solarzelle nach Anspruch 1, wobei der Farbstoff eine Verbindung der Formel:

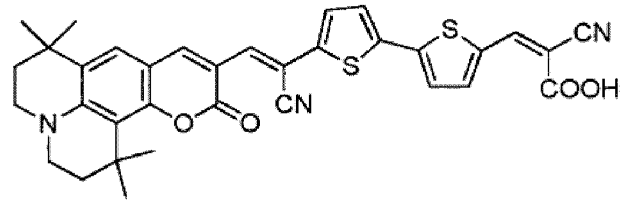
;

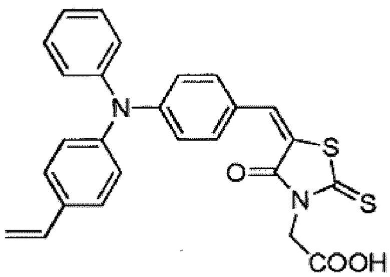
;

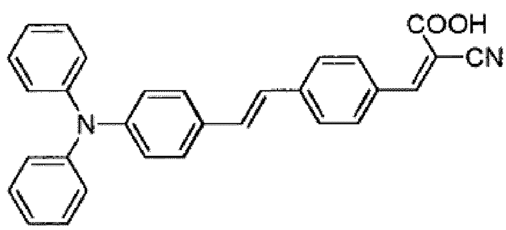
;

oder Mischungen davon umfasst.

4. Farbstoffsensibilisierte Solarzelle nach Anspruch 2, wobei der Prozentanteil von {100} mindestens etwa 51%, mindestens etwa 55%, mindestens etwa 60%, mindestens etwa 65%, mindestens etwa 70%, mindestens etwa 75% oder mindestens etwa 80% beträgt.

5. Farbstoffsensibilisierte Solarzelle nach Anspruch 2, wobei der Prozentanteil von {100}-Kristallflächen 51% bis etwa 80%, z.B. etwa 51% bis etwa 70%, etwa 51% bis etwa 70% oder etwa 51% bis etwa 60% beträgt.

6. Verfahren zur Herstellung einer farbstoffsensibilisierten Solarzelle, bei dem man:

   ein erstes Substrat, das eine erste leitfähige Schicht umfasst, bereitstellt; und
   auf dem Substrat eine $TiO_2$-Nanopartikelschicht bildet, **dadurch gekennzeichnet, dass** die $TiO_2$-Nanopartikelschicht einen höheren Prozentsatz von {100}-Kristallflächen im Verhältnis zu {101}- und {001}-Kristallflächen aufweist.

7. Verfahren nach Anspruch 6, bei dem ein Farbstoff eine Verbindung der Formel:

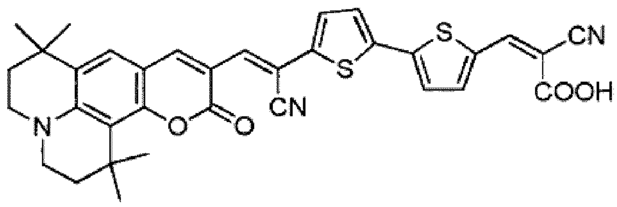
;

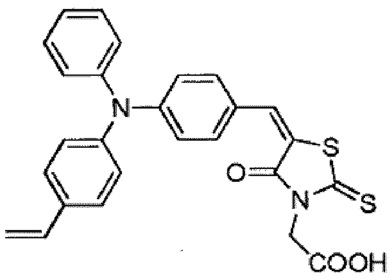
;

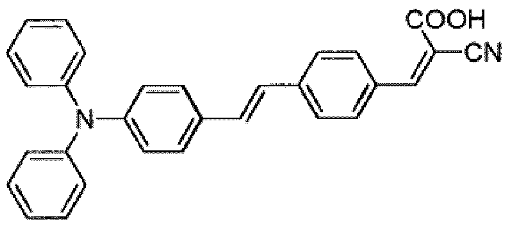
;

   oder Mischungen davon umfasst.

8. Verfahren nach Anspruch 6 zur Herstellung einer farbstoffsensibilisierten Solarzelle, bei dem man:

   auf dem ersten Substrat die erste leitfähige Schicht bildet;
   auf der ersten leitfähigen Schicht eine Barriereschicht bildet;
   die $TiO_2$-Nanopartikelschicht mit einem höheren Prozentsatz von {100}-Kristallflächen im Verhältnis zu {101}- und {001}-Kristallflächen bildet;
   auf der $TiO_2$-Nanopartikelschicht eine $TiO_2$-Mikropartikelschicht bildet;
   auf der $TiO_2$-Nanopartikelschicht und/oder der $TiO_2$-Mikropartikelschicht einen Farbstoff anordnet;
   auf einem zweiten Substrat eine zweite leitfähige Schicht bildet; und
   zwischen der zweiten leitfähigen Schicht und der Barriereschicht eine Regenerationszusammensetzung bereitstellt.

9. Verfahren nach Anspruch 8 oder farbstoffsensibilisierte Solarzelle nach Anspruch 2, wobei das erste und/oder das zweite Substrat Glas oder ein flexibles Polymer umfassen bzw. umfasst.

**10.** Verfahren oder farbstoffsensibilisierte Solarzelle nach Anspruch 9, wobei das erste und/oder das zweite Substrat ein flexibles Polymer, das Poly-(ethylenterephthalat), Poly(ethylennaphthalat) oder Mischungen davon umfasst, umfassen bzw. umfasst.

**11.** Verfahren nach Anspruch 8 oder farbstoffsensibilisierte Solarzelle nach Anspruch 2, wobei die erste leitfähige Schicht Indiumzinnoxid (ITO), aluminiumdotiertes Zinkoxid (AZO), antimondotiertes Zinndioxid (ATO) oder fluordotiertes Zinndioxid (FTO) oder zinndotiertes Indiumoxid umfasst.

**12.** Verfahren nach Anspruch 8 oder farbstoffsensibilisierte Solarzelle nach Anspruch 2, wobei die Regenerationszusammensetzung Iodidionen und Iod umfasst.

**13.** Verfahren nach Anspruch 8 oder farbstoffsensibilisierte Solarzelle nach Anspruch 2, wobei die zweite leitfähige Schicht Platin umfasst.

## Revendications

**1.** Cellule solaire à colorant comprenant un ou plusieurs colorants et une couche de nanoparticules de $TiO_2$, **caractérisée en ce que** la couche de nanoparticules de $TiO_2$ a un pourcentage supérieur de facettes {100} par rapport aux facettes {101} et {001}.

**2.** Cellule solaire à colorant selon la revendication 1, comprenant en outre :

une première couche conductrice disposée sur un premier substrat ;
une couche barrière disposée sur la première couche conductrice ;
une couche de nanoparticules de $TiO_2$ disposée sur la couche barrière ;
une couche de microparticules de $TiO_2$ disposée sur la couche de nanoparticules de $TiO_2$ ;
un colorant disposé sur la couche de nanoparticules de $TiO_2$ et/ou la couche de microparticules de $TiO_2$ ;
une deuxième couche conductrice disposée sur un deuxième substrat ; et
une composition régénérante disposée entre la deuxième couche conductrice et la couche de microparticules de $TiO_2$.

**3.** Cellule solaire à colorant selon la revendication 1, dans laquelle le colorant comprend un composé de formule :

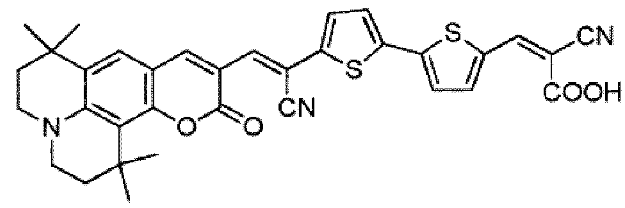

;

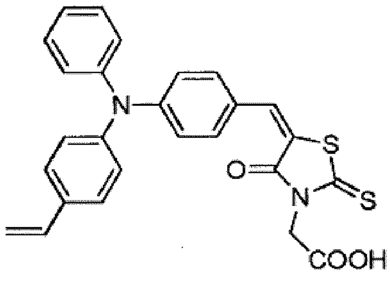

;

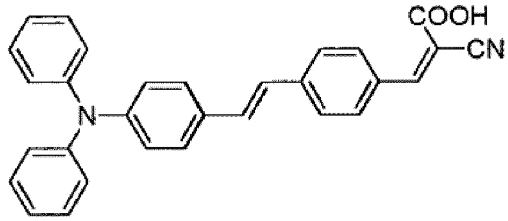

;

ou
mélanges de ceux-ci.

**4.** Cellule solaire à colorant selon la revendication 2, dans laquelle le pourcentage de {100} est d'au moins 51 % environ, au moins 55 % environ, au moins 60 % environ, au moins 65 % environ, au moins 70 % environ, au moins 75 % environ ou au moins 80 % environ.

**5.** Cellule solaire à colorant selon la revendication 2, dans laquelle le pourcentage de facettes {100} est de 51 % à environ 80 %, par ex. environ 51 % à environ 70 %, environ 51 % à environ 70 % ou environ 51 % à environ 60 %.

**6.** Procédé de préparation d'une cellule solaire à colorant comprenant :

l'obtention d'un premier substrat comprenant une première couche conductrice ; et
la formation d'une couche de nanoparticules de $TiO_2$, **caractérisée en ce que** la couche de nanoparticules de $TiO_2$ a un pourcentage supérieur de facettes {100} par rapport aux facettes {101} et {001}, sur le substrat.

**7.** Procédé selon la revendication 6, dans lequel un colorant comprend un composé de formule :

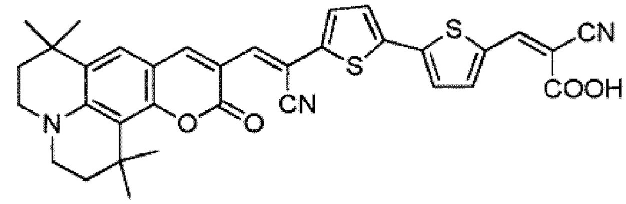

;

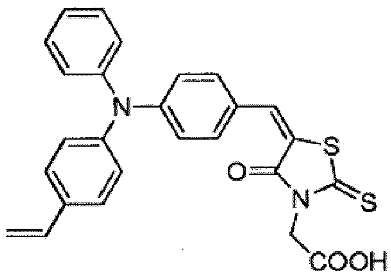

;

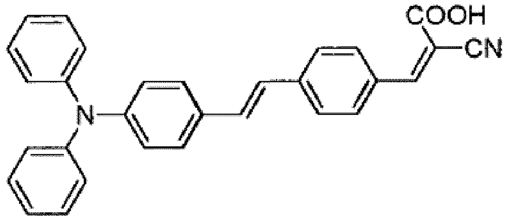

;

ou mélanges de ceux-ci.

**8.** Procédé selon la revendication 6 de préparation d'une cellule solaire à colorant comprenant :

la formation de ladite première couche conductrice sur ledit premier substrat ;
la formation d'une couche barrière sur la première couche conductrice ;
la formation de ladite couche de nanoparticules de $TiO_2$ ayant un pourcentage supérieur de facettes {100} par rapport aux facettes {101} et {001} ;
la formation d'une couche de microparticules de $TiO_2$ sur la couche de nanoparticules de $TiO_2$ ;
la mise en place d'un colorant sur la couche de nanoparticules de $TiO_2$ et/ou la couche de microparticules de $TiO_2$ ;
la formation d'une deuxième couche conductrice sur un deuxième substrat ; et
l'apport d'une composition régénérante entre la deuxième couche conductrice et la couche barrière.

**9.** Procédé selon la revendication 8 ou cellule solaire à colorant selon la revendication 2, le premier et/ou le deuxième substrat comprenant du verre ou un polymère flexible.

**10.** Procédé ou cellule solaire à colorant selon la revendication 9, le premier et/ou le deuxième substrat comprenant un polymère flexible comprenant du poly(téréphtalate d'éthylène), du poly(naphtalate d'éthylène) ou mélanges de ceux-ci.

**11.** Procédé selon la revendication 8 ou cellule solaire à colorant selon la revendication 2, la première couche conductrice comprenant de l'oxyde d'indium et d'étain (ITO), de l'oxyde de zinc dopé à l'aluminium (AZO), du dioxyde d'étain dopé à l'antimoine (ATO) ou du dioxyde d'étain dopé au fluor (FTO), ou de l'oxyde d'indium dopé à l'étain.

**12.** Procédé selon la revendication 8 ou cellule solaire à colorant selon la revendication 2, la composition régénérante comprenant des ions iodure et de l'iode.

**13.** Procédé selon la revendication 8 ou cellule solaire à colorant selon la revendication 2, la deuxième couche conductrice comprenant du platine.

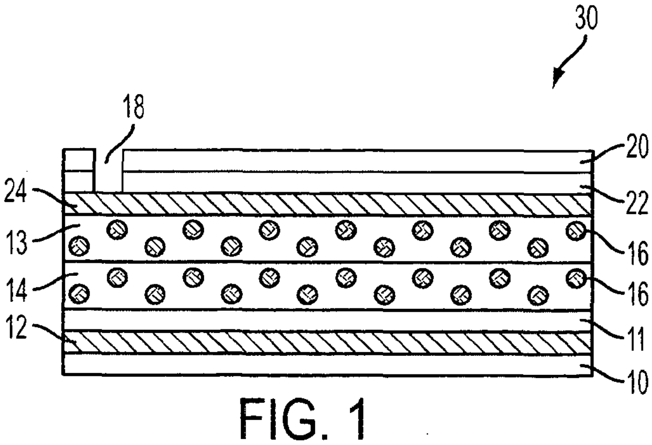


FIG. 1

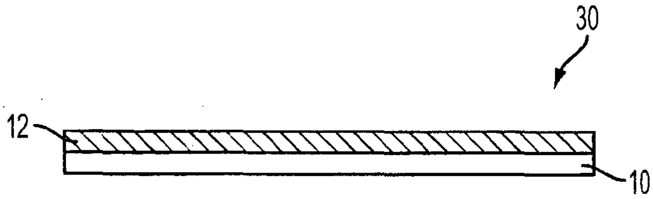


FIG. 2A

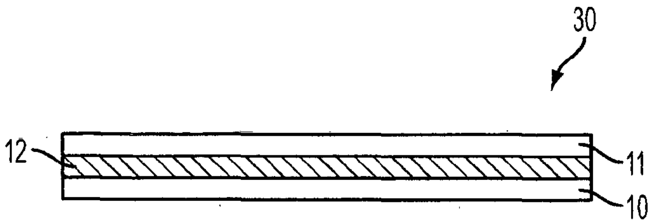


FIG. 2B

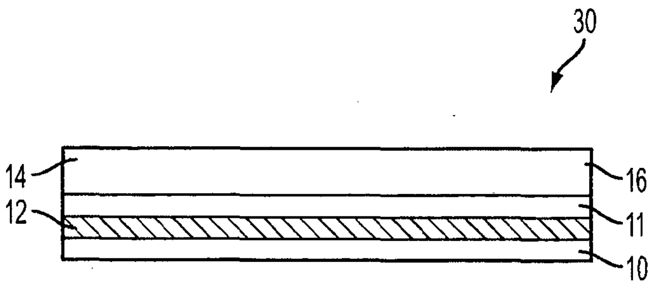


FIG. 2C

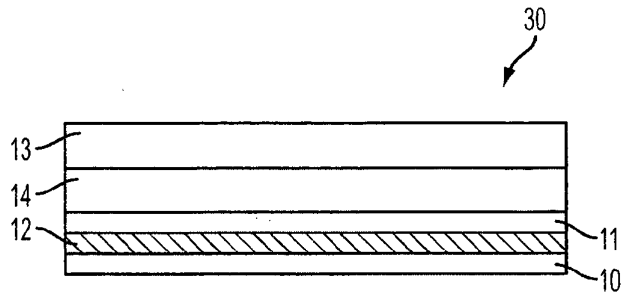


FIG. 2D

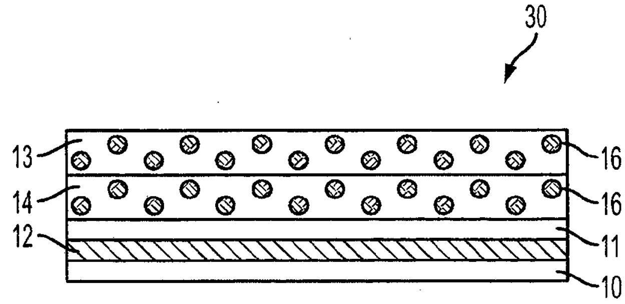


FIG. 2E

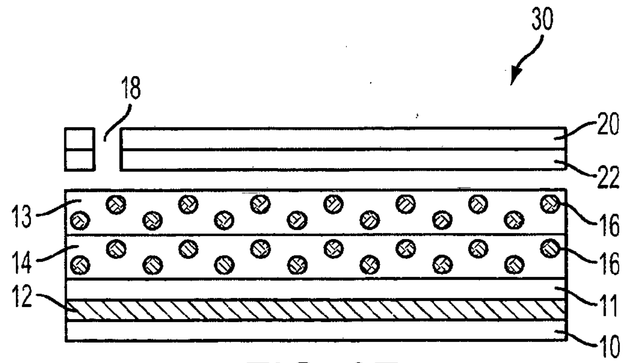


FIG. 2F

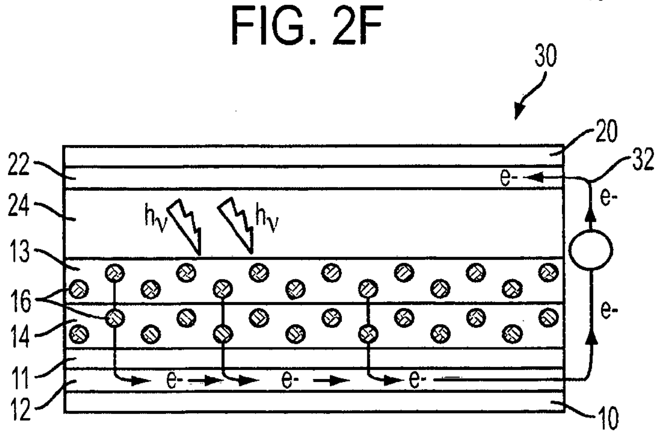


FIG. 3

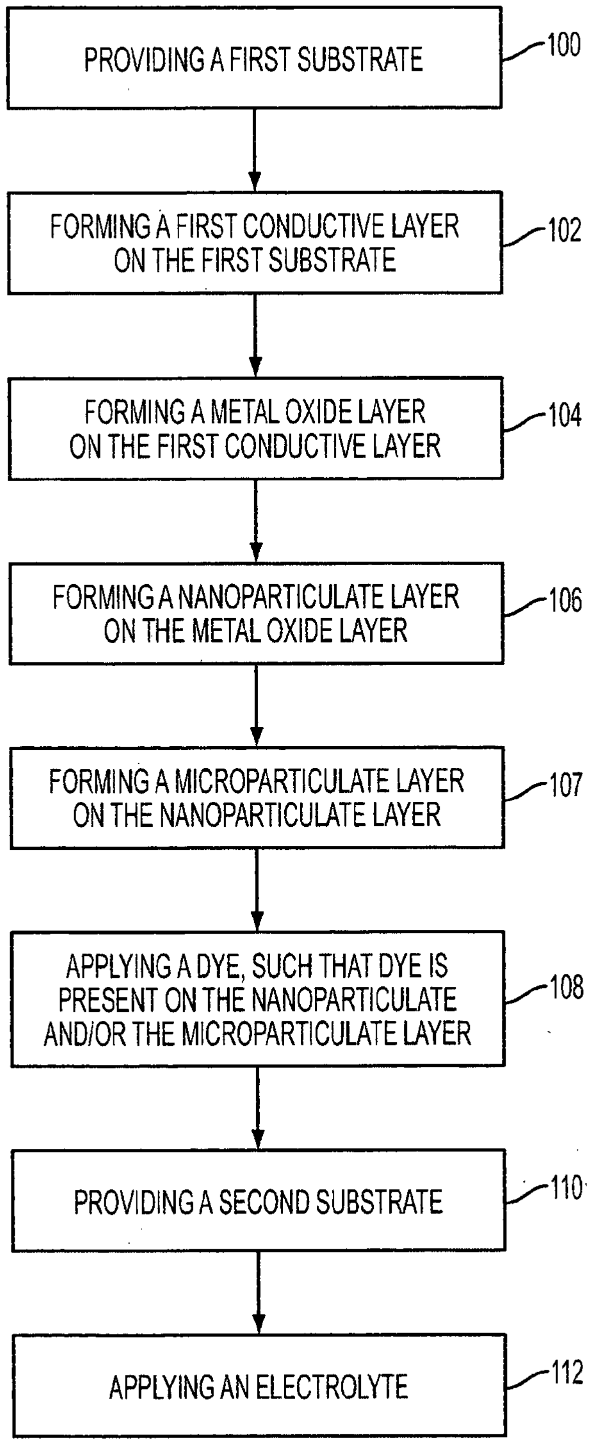
PROVIDING A FIRST SUBSTRATE
100
FORMING A FIRST CONDUCTIVE LAYER ON THE FIRST SUBSTRATE
102
FORMING A METAL OXIDE LAYER ON THE FIRST CONDUCTIVE LAYER
104
FORMING A NANOPARTICULATE LAYER ON THE METAL OXIDE LAYER
106
FORMING A MICROPARTICULATE LAYER ON THE NANOPARTICULATE LAYER
107
APPLYING A DYE, SUCH THAT DYE IS PRESENT ON THE NANOPARTICULATE AND/OR THE MICROPARTICULATE LAYER
108
PROVIDING A SECOND SUBSTRATE
110
APPLYING AN ELECTROLYTE
112

FIG. 4

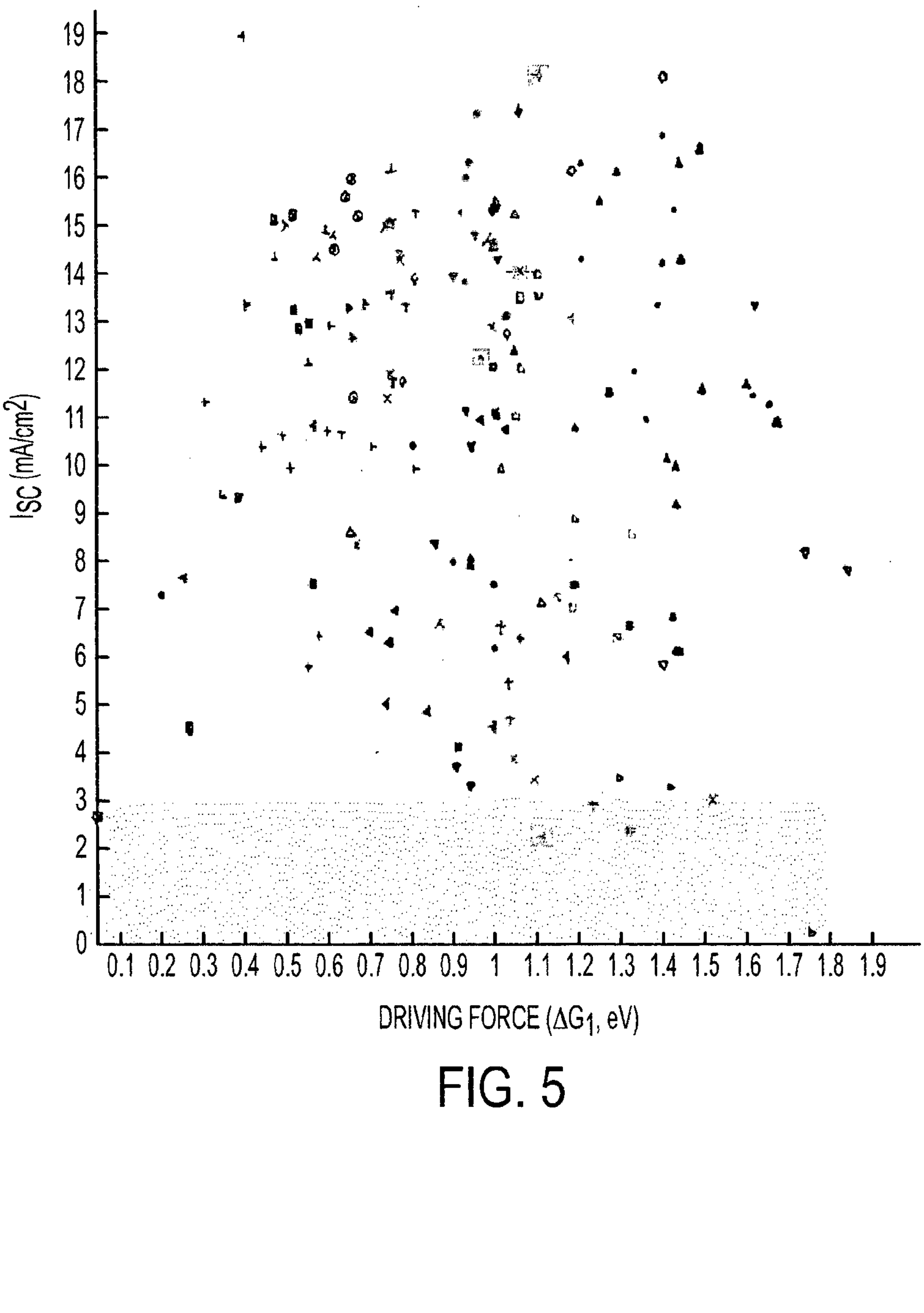
19
18
17
16
15
14
13
12
11
10
9
8
7
6
5
4
3
2
1
0
ISC (mA/cm2)
0.1 0.2 0.3 0.4 0.5 0.6 0.7 0.8 0.9 1 1.1 1.2 1.3 1.4 1.5 1.6 1.7 1.8 1.9
DRIVING FORCE (ΔG1, eV)

FIG. 5

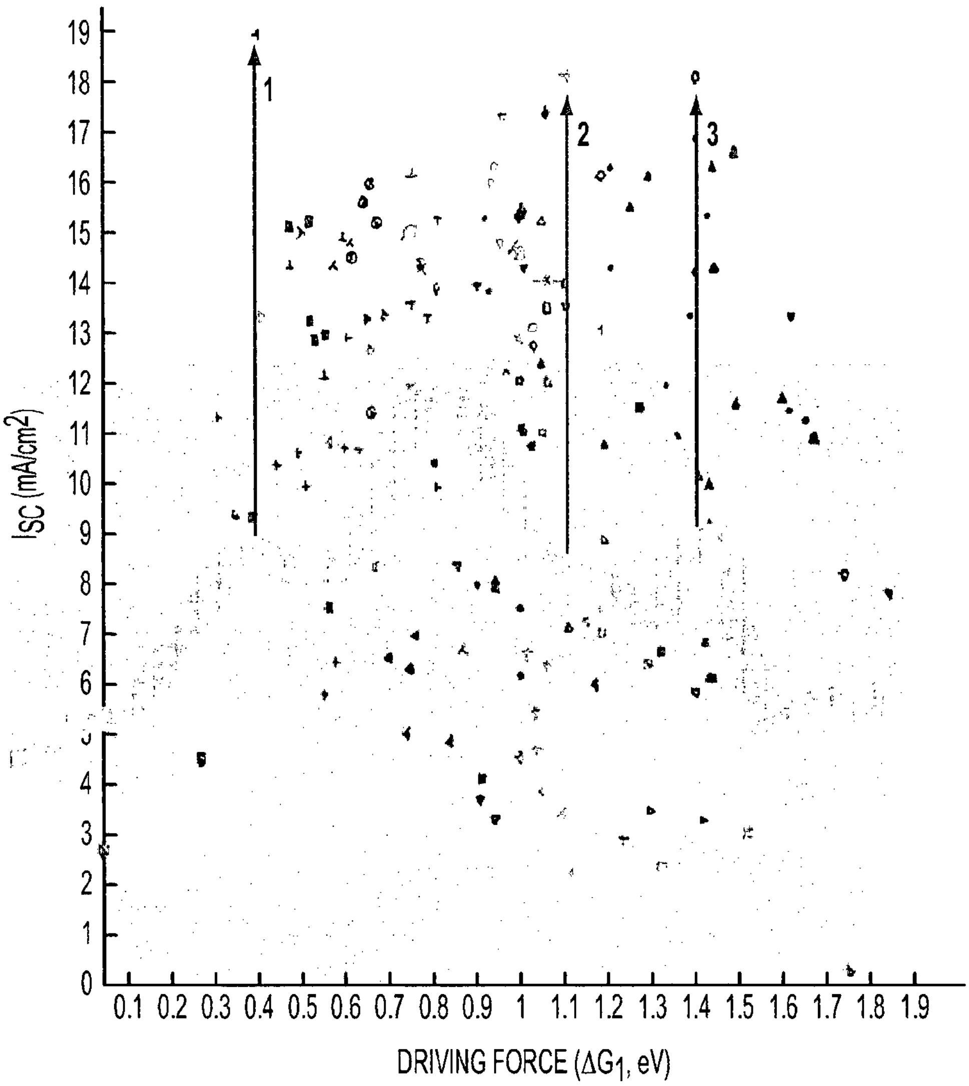
ISC (mA/cm2)
19
18
17
16
15
14
13
12
11
10
9
8
7
6
5
4
3
2
1
0
0.1 0.2 0.3 0.4 0.5 0.6 0.7 0.8 0.9 1 1.1 1.2 1.3 1.4 1.5 1.6 1.7 1.8 1.9
DRIVING FORCE (ΔG1, eV)
1
2
3

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20080041446 A
- US 8034260 B
- US 8222515 B


### Non-patent literature cited in the description


- **M. GRÄTZEL.** *Journal of Photochemistry and Photobiology C: Photochemistry Reviews,* 2003, vol. 4, 145-153
- **WEI-HAO LAI et al.** *Journal of Photochemistry and Photobiology A: Chemistry,* 2008, vol. 195, 307-313
- **XIAO-FENG WANG et al.** *Langmuir,* 2010, vol. 26, 6320-6327
- Nano sized anatase TiO2 single crystals with tunable exposed (001) assets for enhanced energy conversion efficiency of dye-sensitised solar cells. **XIA WU et al.** advanced functional materials. Wiley, 08 November 2011, vol. 21, 4167-4172
- **J. LI ; D. XU.** *Chem. Commun.,* vol. 46, 2301
- **WANG et al.** *Adv. Mater,* 2007, vol. 19, 1138
- **LIANG et al.** *J. Phys. Chem.,* 2007, vol. 111, 4464
- **HWANG.** *Chem. Commun,* 2007, 4887
- **A. MISHRA et al.** *Angew. Chem. Int. Ed.,* 2009, vol. 48, 2474-2499
- **Z. ZHAO et al.** *Journal of Physics: Condensed Matter,* 2010, vol. 22, 175008
- **HWANG.** *Chem. Commun.,* 2007, 4887